Europäisches Patentamt

European Patent Office

Office européen des brevets

(11) Veröffentlichungsnummer: **0 492 114 A1**

# EUROPÄISCHE PATENTANMELDUNG

(21) Anmeldenummer: **91119311.8**

(51) Int. Cl.⁵: **C23C 14/34**, C23C 14/56

(22) Anmeldetag: **13.11.91**

(30) Priorität: **20.12.90 DE 4040856**

(43) Veröffentlichungstag der Anmeldung:
**01.07.92 Patentblatt 92/27**

(84) Benannte Vertragsstaaten:
**CH DE FR GB IT LI NL**

(71) Anmelder: **LEYBOLD AKTIENGESELLSCHAFT**
**Wilhelm-Rohn-Strasse 25, Postfach 1555**
**W-6450 Hanau am Main 1(DE)**

(72) Erfinder: **Moses, Gerhard, Dipl.-Ing.**
**Weissdornweg 16**
**W-6450 Hanau 8(DE)**
Erfinder: **Michael, Klaus, Dr.**
**Schöne Aussicht 16a**
**W-6460 Gelnhausen 4(DE)**
Erfinder: **Path, Ulrich, Dr.**
**Waldstrasse 26**
**W-6464 Linsengericht 2(DE)**
Erfinder: **Scherer, Michael, Dr.**
**Im Heegholz 1 a**
**W-6458 Rodenbach(DE)**

(74) Vertreter: **Schickedanz, Willi, Dipl.-Ing.**
**Langener Strasse 68**
**W-6050 Offenbach/Main(DE)**

(54) **Zerstäubungsanlage.**

(57) Die Erfindung betrifft eine Zerstäubungsanlage mit einer Elektrode (3) und einem mit dieser Elektrode (3) verbundenen Target (2), wobei dieses Target (2) austauschbar ist. Hierbei wird ein verbrauchtes Target (2) durch ein frisches und vorgesputtertes Target (7) ersetzt, indem die komplette Elektrode (3) durch eine neue Elektrode (6) ersetzt wird.

FIG.1

Die Erfindung betrifft eine Zerstäubungsanlage nach dem Oberbegriff des Patentanspruchs 1.

In der Vakuum-Beschichtungstechnik werden in der Regel dünne Schichten eines ersten Materials auf ein zweites Material aufgebracht. Beispiele hierfür sind Anwendungen in der Elektronik, wo Widerstandsschichten, Leiterbahnschichten oder Isolatorschichten etc. aufgebracht werden, oder in der Optik, wo Entspiegelungsschichten, Sonnenschutzschichten, Kantenfilter oder Linienfilter mittels dünner Schichten hergestellt werden. Als eine besonders in der Produktion vorteilhafte Methode, diese Schichten herzustellen, hat sich das Sputter- oder Zerstäubungsverfahren erwiesen. Hierbei werden geladene Teilchen eines Gases oder Gasgemisches durch ein elektrisches Feld auf ein aus dem Beschichtungsmaterial oder einer Komponente des Beschichtungsmaterials bestehendes sogenanntes Target beschleunigt. Diese geladenen Teilchen schlagen aus dem Target Material heraus, das sich auf dem Substrat niederschlägt. Um Reaktionen mit dem Targetmaterial zu vermeiden, verwendet man üblicherweise hochreine Edelgase zur Zerstäubung. Das Targetmaterial kann sich durch entsprechende Wahl des Zerstäubungsgases und der übrigen Zerstäubungsbedingungen aber auch auf der Targetoberfläche, auf dem Weg zum Substrat oder auf dem Substrat selbst mit einem reaktionsfähigen Gas, z. B. bei Verwendung von $O_2$ oder $N_2$ zur Herstellung von Oxiden oder Nitriden, verbinden. Besonders störend für eine zuverlässige Schichtherstellung ist eine Verunreinigung der Targetoberfläche, die insbesondere bei reaktionsfähigen Materialien, z. B. bei Belüftung des Materials oder bei oberflächenhafter "Vergiftung" des Materials durch reaktive Komponenten im Sputtergas entstehen kann. Derartige Verunreinigungen führen zu unstabilen Prozeßbedingungen. Bekannt Beispiele hierfür sind die Herstellung von In-Sn-Oxid oder Si-Nitrid. Daher werden diese Materialien in der Regel vor dem Herstellen der Schicht oder auch nach gewissen Zeiten während der Schichtherstellung "konditioniert", d. h. sie werden solange mit einem Edelgas, gegebenenfalls auch unter Beimengung von reduzierenden Gaskomponenten, vorgesputtert, bis die Prozeßparameter sich stabilisiert haben. Diese Vorbehandlung ist zeitaufwendig, so daß der Produktionsprozeß für längere Zeit unterbrochen werden muß.

Es ist bereits eine Targetwechselvorrichtung bekannt, die eine drehbare Targetplatte mit mehreren Targets aufweist (DD 111 409). Die einzelnen Targets werden hierbei nacheinander in Gegenposition zu einem Substrat gebracht. Es findet jedoch keine Vorbehandlung der Targets in einer besonderen Vorkammer statt. Nach dem Verbrauch eines Targets muß die ganze Vorrichtung belüftet werden.

Weiterhin ist eine Sputtervorrichtung bekannt, mit der verschiedene Schichten auf einem Substrat aufgebracht werden können (US-A-3 420 767). Diese Vorrichtung kann jedoch nur bei speziellen Stabelektroden zum Einsatz kommen. Außerdem ist beim Austausch eines verbrauchten Targets eine Vakuumunterbrechung erforderlich.

Bei einer anderen Targetwechselvorrichtung werden mehrere Targets durch ein Target-Karussell gedreht und nacheinander gegenüber einem Substrat positioniert (US-A-3 853 740). Eine Vorbehandlung von Targets vor ihrem Einsatz als Arbeitstargets findet hierbei nicht statt.

Um eine Mehrkomponentenschicht herzustellen, ist es bekannt, mehrere kubische oder parallelepipedförmige Targets auf einer Platte anzuordnen und nacheinander zu einem Substrat zu führen (Japan 1-290767 (A)). Ein Nachrüsten von Targets ist hierbei ebenfalls nur nach dem Belüften der ganzen Anlage möglich.

Bei einer weiteren bekannten Anlage für die Herstellung von optischen Mehrschicht-Filmen wird eine Vorkonditionierung - die als solche bekannt ist, vgl. John L. Vossen, Werner Kern: Thin Film Processes, Academic Press, 1978, S. 41 bis 42 - von keramischen Materialien vorgenommen, damit diese Materialien gesäubert werden (US-A-4 142 958). Verschiedene Kammern, in denen die Targets nacheinander eingebracht werden, sind hierbei jedoch nicht vorgesehen.

Eine weitere Drehvorrichtung, mit der mehrere Targets nacheinander in eine Position gebracht werden können, die einem Substrat gegenüberliegt ist aus der japanischen Patentschrift 63-42 368 bekannt. Aber auch bei dieser Vorrichtung findet keine Präkonditionierung von Targets statt.

Es ist ferner eine Vorrichtung für die Oberflächenbeschichtung bekannt, bei der mehrere Teilchen-Emissionsquellen mit einem Träger verbunden sind, der geradlinig oder im Kreis herum bewegt werden kann (US-A-3 616 451 = CH-A-501 063). Auch für diese Vorrichtung gilt, daß sie zur Aufnahme neuer Targets belüftet werden muß.

Des weiteren ist eine Targetaustauschvorrichtung bekannt, die zwei verschiedene Kammern aufweist (US-A-3 756 939). In der einen Kammer befindet sich ein Substrat, dem ein Arbeitstarget gegenüberliegt, während sich in der anderen Kammer Reserve-Targets befinden, von denen ein Target nach dem Verbrauch des Arbeitstargets an dessen Stelle tritt. Eine Vorkonditionierung des Reserve-Targets findet hierbei indessen nicht statt.

Schließlich ist auch noch eine Sputtervorrichtung mit einem Vakuumgefäß vorgeschlagen worden, in dem ein Substrathalter angeordnet ist, wobei ein Target einem Substrathalter gegenübersteht (DE-A-4 037 580). In derjenigen Oberfläche des Vakuumgefäßes, die dem Substrathalter gegenüberliegt, ist eine Öffnung vorhanden. Außerdem liegt das Vakuumgefäß benachbart zu einer Targetwechselkammer, die über die Öffnung mit dem Vakuumgefäß in Verbindung steht, wobei die Öffnung durch die Targetelektrode verschlossen wird. Die Targetwechselkammer wird evakuiert und während des Auswechselns des Targets durch eine Ersatzelektrode im evakuierten Zustand gehalten.

Der Erfindung liegt die Aufgabe zugrunde, eine Zerstäubungsanlage zu schaffen, mit welcher der Produktionsprozeß zum Targetwechsel oder allgemein zum Targetkonditionieren nur kurzfristig oder gar nicht unterbrochen werden muß.

Diese Aufgabe wird gemäß den Merkmalen des Patentanspruchs 1 gelöst.

Der mit der Erfindung erzielte Vorteil besteht insbesondere in der Erhöhung der Verfügbarkeit einer Zerstäubungsanlage. Die erfindungsgemäße Targetwechselvorrichtung ist außerdem für alle Anlagentypen geeignet, z. B. für Batchtype-Anlagen oder Load-lock-Anlagen.

Ausführungsbeispiele der Erfindung sind in der Zeichnung dargestellt und werden im folgenden näher beschrieben. Es zeigen:

Fig. 1 eine schematische Darstellung einer erfindungsgemäßen Zerstäubungsanlage mit einer Arbeitskammer, einer Vorkammer und einer ersten Varianten einer Doppelelektrode;

Fig. 2 eine Vorkammer mit einer zweiten Varianten einer Doppelelektrode;

Fig. 3 eine Vorkammer mit einer dritten Varianten einer Doppelelektrode;

Fig. 4 eine Vorkammer mit zwei durch Um-Klappen austauschbaren Elektroden.

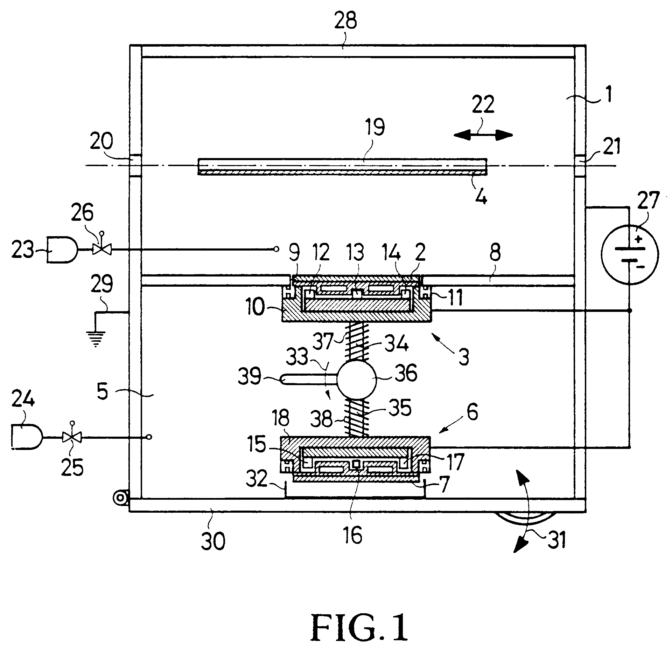

In der Fig. 1 ist eine Arbeitskammer 1 dargestellt, in der sich ein Beschichtungsvorgang abspielt, bei dem Teilchen aus einem Target 2 herausgeschlagen werden, das Teil einer sogenannten Sputter- oder Zerstäubungskathode 3 ist. Die herausgeschlagenen Teilchen gelangen auf ein Substrat 4, das sich in der Arbeitskammer befindet, und beschichten bzw. ätzen dieses. An die Arbeitskammer 1 schließt sich eine Vorkammer 5 an, in der sich eine Austauschkathode 6 mit einem Austauschtarget 7 befindet. Sowohl bei der Arbeitskammer 1 als auch bei der Vorkammer 5 handelt es sich um Kammern, in denen im wesentlichen die gleichen Bedingungen herrschen.

Die Arbeitskammer 1 ist von der Vorkammer 5 durch eine Wand 8 mit einer Öffnung 9 getrennt. Durch diese Öffnung 9 greift von der Vorkammer 5 her das Target 2, das an der Kathode 3 befestigt ist, in die Arbeitskammer ein. Die Kathode 3 weist einen Grundkörper 10 auf, der über einen Isolierring 11 auf der Zwischenwand 8 aufsitzt. In der Kathode 3 befinden sich beispielsweise Dauermagnete 12, 13, 14 für die Erzeugung eines Magnetfelds, das für eine Elektronen-Zyklotronen-Resonanz erforderlich ist. Die Kathode 6 ist entsprechend aufgebaut und weist die Dauermagnete 15, 16, 17 sowie einen Grundkörper 18 auf.

Das Substrat 4 befindet sich auf einem Träger 19, der horizontal oder vertikal durch Öffnungen 20, 21 bewegt werden kann, was durch einen Doppelpfeil 22 angedeutet ist. In den Öffnungen 20, 21 können sich besondere und in der Fig. 1 nicht dargestellte Schleusen befinden.

Sowohl die Arbeitskammer 1 als auch die Vorkammer 5 werden aus Behältern 23, 24 und über Ventile 25, 26 mit Gas versorgt. Desgleichen liegen beide Kathoden 3, 6 an dem negativen Anschluß einer Gleichspannungsquelle 27.

Arbeitskammer 1 und Vorkammer 5 werden von demselben Gehäuse 28 umschlossen, das an Masse 29 liegt, wobei die Vorkammer 5 eine Tür 30 besitzt, die in Richtung des Pfeils 31 geöffnet und geschlossen werden kann. Auf der Innenseite der Tür 30 befindet sich eine Anode 32. Da sie über die elektrisch leitende Türinnenseite und das Gehäuse 28 an Masse 29 liegt, ist die gegenüber der Kathode 6 positiv vorgespannt.

Die beiden Kathoden 3 und 6 sind über eine Vorrichtung miteinander verbunden, die eine relative Annäherung oder Entfernung der beiden Kathoden 3, 6 ermöglicht. Wird beispielsweise ein Hebel 39 in Richtung eines Pfeils 33 bewegt, so nähern sich die Elektroden 3, 6 durch Heranführen von Bolzen 34, 35 an ein Zentrum 36. Durch diese Annäherung ist es möglich, die gesamte Vorrichtung mit den Elektroden 3, 6, den Bolzen 34, 35 und dem Zentrum 36 zu drehen und die Elektrode 6 an die bisherige Stelle der Elektrode 3 zu bewegen.

Im einzelnen erfolgt der Austausch der beiden Kathoden 3, 6 auf folgende Weise: Ist das Target 2 aufgrund des Sputtervorgangs verbraucht und muß es durch ein neues Target 7 ersetzt werden, so werden die Kathoden 3, 6 durch Betätigen des Hebels 39 und gegen die Kraft von Federn 37, 38 zusammengedrückt. Jetzt wird die gesamte Vorrichtung um 180 Grad gedreht, so daß die Kathode 6, die zuvor mittels der Anode 32 vorgesputtert wurde, an die Stelle der Kathode 3 gelangt. Die Kathode 3 gelangt dagegen an diejenige Stelle, an der sich zuvor die Kathode 6 befand. Der Sputterbetrieb kann also ohne große Verzögerung mit dem frischen Target 7 fortgesetzt werden.

Das alte Target 2 wird entfernt, indem die Tür 30 geöffnet und das Target 2 von der Elektrode 3 abmontiert wird. Anschließend wird das verbrauchte Target 2 durch ein neues oder zwischengereinigtes Target ersetzt, die Tür 30 wieder geschlossen und das neue Target für den Einsatz in der Arbeitskammer 1 vorbereitet. Durch die sofortige Verfügbarkeit des neuen Targets nach Verbrauch des alten Targets kann auf eine Außerbetriebsetzung der Sputteranlage verzichtet werden.

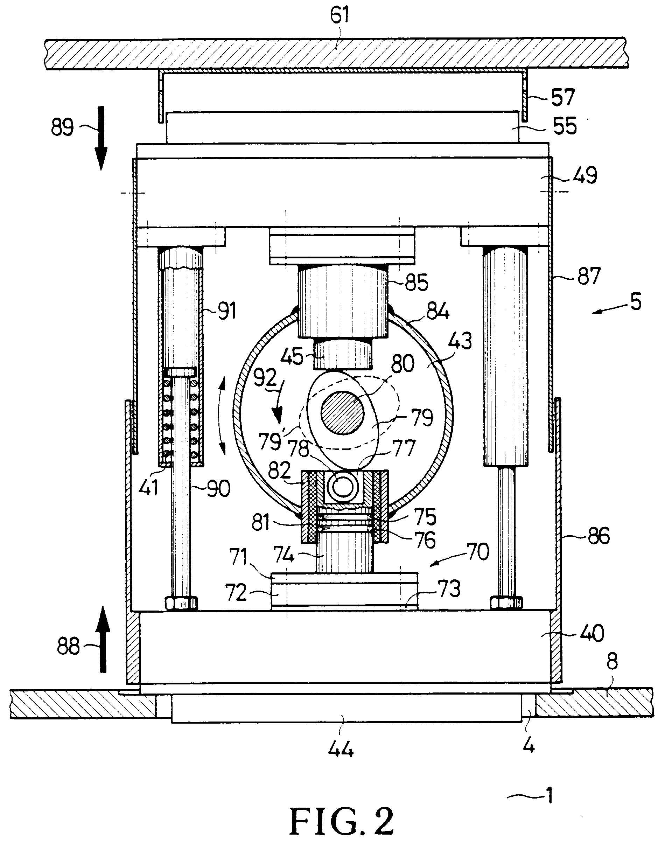

In der Fig. 2 ist eine weitere Ausführungsform der Erfindung dargestellt, wobei die Einzelheiten der Arbeitskammer 1 weggelassen wurden. Die Trennwand 8 zwischen Arbeitskammer 1 und Vorkammer 5 ist nur andeutungsweise dargestellt. An einem Elektroden-Grundkörper 40 ist ein Teil 70 mit drei Scheibenelementen 71, 72, 73 und einem Zapfen 74 angeflanscht. Dieser Zapfen 74 weist in seinem oberen Bereich zwei Nuten 75, 76 fürjeweils einen O-Ring und eine im Querschnitt U-förmige Ausnehmung 77 auf, in der sich ein zylindrisches Kugel- oder Nadellager 78 befindet. Auf diesem Lager 78 ruht ein Exzenter 79, der eine Drehwelle 80 aufweist. Der obere Bereich des Zapfens 74 ist von einer Lager- und Isolierbuchse 81 umgeben, die von einem Führungslager bzw. einer Lagerbuchse 82 umschlossen ist. Mit 84 ist ein Rohr bezeichnet, welches in die Zeichenebene hineinragt und oben und unten abgedichtet aus der Vorsputterkammer herausgeführt ist. Dieses Rohr 84 weist in seinem Innenraum 43 Atmosphärendruck auf. Es wirkt außerdem als Halterung für die beiden Kathodengrundkörper 40, 49. Hierdurch bedingt kann die Kühlwasserzuführung und Stromzuführung zur Kathode im Rohr 84 und damit an der Atmosphäre erfolgen.

Bei den Positionen 86 und 87 handelt es sich um Abschirmbleche, die ein Besputtern der Axialführung der Kathode, d. h. des Lagerbolzens 74 verhindern sollen. Diese Abschirmbleche 86, 87 sind, abhängig von der Form der jeweiligen Kathode, in Kastenform oder Zylinderform um die Kathode angeordnet.

Soll das verbrauchte Target 44 gegen das unverbrauchte und aufbereitete Target 55 ersetzt werden, so werden die Führungen 74, 45 in Richtung der Pfeile 88, 89 gegeneinander verschoben. Die Kraft wird durch eine Teleskop-Verbindung 90, 91 zwischen den beiden Elektroden 40, 49 aufgebracht. Hierzu wird zunächst die Exzenterwelle 80 beispielsweise mittels eines nicht dargestellten Hebels in Richtung des Pfeils 92 verdreht. Der Exzenter 79, der zuvor entgegen der von der Teleskopverbindung 90, 91 aufgebrachten Kraft den Abstand zwischen den Zylindern 82, 85 groß gehalten hat, nimmt beispielsweise die mit 79' bezeichnete Position ein und verringert nun diesen Abstand und ermöglicht hierdurch ein weiteres Eindringen des Führungslagers 74 in vertikaler Richtung in die Lagerbuchse 81. Ist der Abstand zwischen den Elektroden 40, 49 hinreichend verringert, wird die gesamte Anordnung mittels dem Rohr 84, an dem sich z. B. ein nicht dargestellter Griff befindet, um 180° um die Exzenterwelle 80 geschwenkt, so daß das Target 55 an die Stelle des verbrauchten Targets 44 gelangt. Das verbrauchte Target 44 kann nun gegen ein neues Target ausgetauscht werden.

Es finden also zwei Vorgänge nacheinander statt. Bei dem ersten Vorgang rollt der Exzenter 79 auf dem Walzenlager 78 ab und nimmt die gestrichelt gezeichnete Position 79' ein. Hat er diese Position eingenommen, wird diegesamte Anlage mit den Elektroden 40, 49 durch Drehen des Rohrs 84 um 180 Gradverschoben. Nach der 180°-Drehung wird die Welle 80 entgegen der Richtung des Pfeils 92 gedreht, so daß der alte Abstand zwischen den beiden Elektroden 40, 49 wieder hergestellt ist.

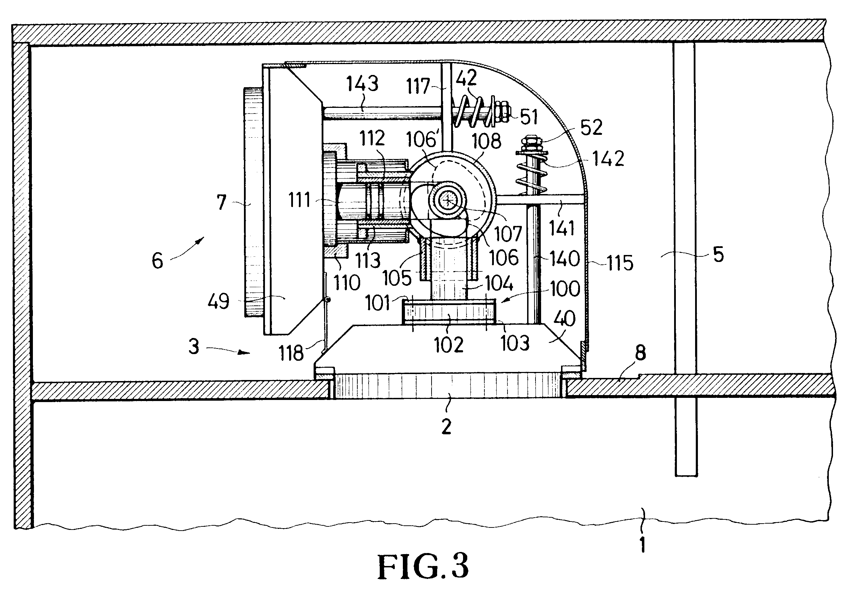

In der Fig. 3 ist eine weitere Variante der erfindungsgemäßen Vorrichtung dargestellt, die sich von den vorbeschriebenen Varianten dadurch unterscheidet, daß das Austauschtarget 7 nichtum 180 Grad, sondern nur um 90 Grad geschwenkt wird. Das Arbeitstarget 2, welches in die Arbeitskammer 1 hineinragt, ist mit dem Grundkörper 40 der Elektrode 3 gekoppelt, die ihrerseits mit einem Kathodenanschluß 100 verbunden ist, der drei Teile 101, 102, 103 und einen Zapfen 104 aufweist, der von einer Lagerbuchse 105 umgeben ist. Dieser Zapfen 104 stößt auf einen Exzenter 106, der eine Exzenterwelle 107 aufweist, während die Lagerbuchse 105 mit einem Zylinderrohr 108 verbunden ist, der den Exzenter 106 umgibt. Das Ersatztarget 7 ist mit einem Elektrodengrundkörper 49 verbunden, der eine Buchse 110 und einen Zapfen 111 aufweist. Dieser Zapfen 111 ist von einer Lagerbuchse und Isolierung 112 umgeben, an die ein Zylinder 113 anschließt, der von einer Spiralfeder 114 umgeben ist. Das Ende des Zapfens 111 stößt an den Exzenter 106. Eine Abschirmung 115 umfaßt beide Elektroden 3, 6. Die Strebe 117 kann am Rohr 108 befestigt werden. Entsprechendes gilt für eine Strebe 141. Beide Streben 117, 141 führen jeweils einen Bolzen 140, 143, der in seinem oberen Bereich einen Kopf 51, 52 aufweist, gegen sich eine Feder 42 bzw. 142 mit ihrem einen Ende abstützt Das andere Ende der Feder 42, 142 stützt sich gegen die Streben 17, 141 ab.

Der Vorgang, der sich beim Austausch eines verbrauchten Targets 2 gegen ein neues Target 7 abspielt, ist folgender: Mit Hilfe einer nicht dargestellten Vorrichtung wird die Exzenterwelle 107 gedreht, worauf der Exzenter 106 seine Position verläßt, in der er auf die Zapfen 104, 111 stößt. Hat der Exzenter 106 seine gestrichelt dargestellte Position 106' erreicht, so haben sich die beiden Zapfen 104, 111 einander genähert, d. h. die Targets 2,7 befinden sich nun näher an der Exzenterwelle als vorher. Mit Hilfe einer nicht dargestellten Vorrichtung wird jetzt der Zylinder 108 um 90 Grad gedreht, so daß das Target 7 diejenige Stelle einnimmt, die zuvor vom Target 2 eingenommen wurde.

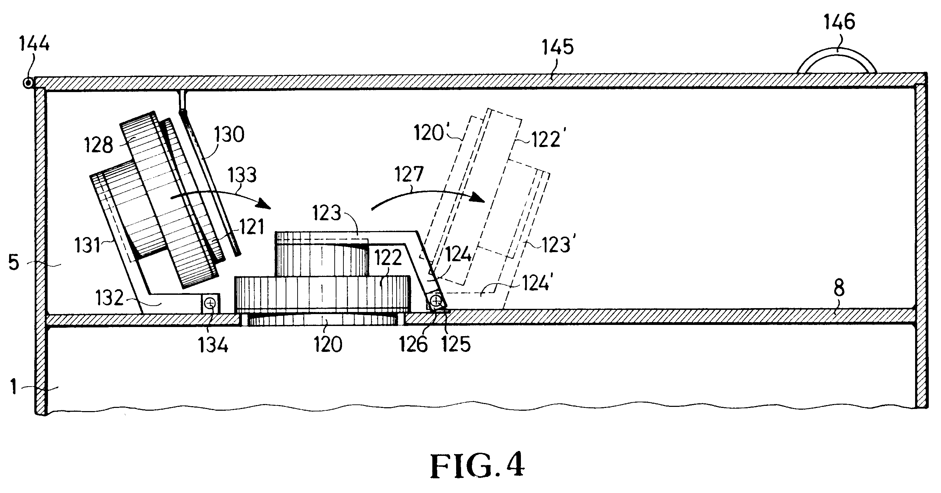

In der Fig. 4 ist eine weitere Variante der Erfindung dargestellt, bei der nur die wesentlichsten Teile gezeigt sind.

In die Arbeitskammer 1 ragt ein Target 120, das mit einer zugehörigen Elektrode 122 verbunden ist. Die Elektrode 122 ist über einen waagrechten Arm 123 und einen daran anschließenden, schräg nach unten verlaufenden Arm 124 miteinem Drehlager 125 verbunden, das sich in einem Lagerbock 126 befindet, der auf der Trennwand 8 zwischen Arbeitskammer 1 und Vorkammer 5 angeordnet ist.

Ist das Target 120 verbraucht, wird die gesamte Elektrode 122 mit dem Target 120 in Richtung des Pfeils 127 geschwenkt und in die Position gebracht, in der die Bezugszahlen mit Apostrophen versehen sind. In dieser Position kann eine Reserveelektrode 128, deren Target 121 über eine Anode 130 vorgesputtert ist, mittels ihrer Schwenkarme 131, 132 in die frühere Position der Elektrode 122 gebracht werden. Hierzu wird die Reserveelektrode 128, nachdem die Anode 130 weggeklappt wurde, in Richtung des Pfeils 133 und um die Diehachse 134 bewegt. Sie nimmt nun die Position der früheren Elektrode 122 ein.

Obwohl in den Zeichnungen nur eine Stromversorgung dargestellt ist, versteht es sich, daß für mehrere Elektroden auch mehrere Stromversorgungen verwendet werden können. Außerdem müssen die Elektroden nicht als konkrete mechanische Vorrichtungen ausgebildet sein. Wesentlich ist nur das elektrische Potential, das zum Beispiel auch am Gehäuse selbst anliegen kann.

**Patentansprüche**

1. Zerstäubungsanlage mit
   a) einer Arbeitskammer (1) mit einem ersten vorgegebenen Volumen, in der sich ein Substrat (4) befindet, das mit gesputtertem Material beaufschlagt wird;
   b) ein erstes Target (2), das gesputtert wird und das sich gegenüber dem Substrat (4) befindet, wobei dieses Target mit einer ersten Elektrode (3) verbunden ist;
   c) eine Vorkammer (5) mit einem zweiten vorgegebenen Volumen, die wenigstens ein zweites Target (7) aufweist, wobei dieses Target mit einer zweiten Elektrode (6) verbunden ist, welche dasselbe Potential wie die erste Elektrode (3) besitzt;
   d) eine Wand (8), welche die Arbeitskammer (1) von der Vorkammer (5) trennt;
   e) eine dritte Elektrode (32), die sich in der Vorkammer (5) befindet, wobei diese dritte Elektrode (32) dem zweiten Target (7) gegenüberliegt und ein Potential besitzt, das sich vom Potential der ersten und zweiten Elektrode (3, 6) unterscheidet;

   f) eine Einrichtung (34 bis 39, 123, 124, 131, 132), welche das zweite Target (7) an die Stelle des ersten Targets (2) bringt und das erste Target (2) aus der Arbeitskammer (1) entfernt.

2. Zerstäubungsanlage nach Anspruch 1, **dadurch gekennzeichnet**, daß die erste Elektrode (3) mit einem verbrauchten Target (2, 44, 120) durch eine Elektrode (6, 49, 128) mit einem neuen Target (7, 55, 121) ersetzt wird, wobei das neue Target (7, 55, 121) vorgesputtert ist.

3. Zerstäubungsanlage nach Anspruch 1, **dadurch gekennzeichnet**, daß die ersten Elektroden (3; 40) und die zweiten Elektroden (6; 49) derart miteinander gekoppelt sind, daß sie aufeinander zubewegt und um eine Drehachse (36, 80, 107) um 180° gedreht werden können.

4. Zerstäubungsanlage nach Anspruch 1, **dadurch gekennzeichnet**, daß die ersten Elektroden (3; 40) und die zweiten Elektroden (6; 49) derart miteinander gekoppelt sind, daß sie relativ zueinander verschoben und um eine Drehachse (36, 80, 107) um 90° gedreht werden können.

5. Zerstäubungsanlage nach Anspruch 1, **dadurch gekennzeichnet**, daß eine Drehachse (36) mit Stangen (34, 35) vorgesehen ist, die jeweils eine Elektrode (3, 6) tragen.

6. Zerstäubungsanlage nach Anspruch 1, **dadurch gekennzeichnet**, daß der Abstand zwischen den ersten Elektroden (3; 40) und den zweiten Elektroden (6; 49) mittels eines Exzentersystems (79, 106) veränderbar ist.

7. Zerstäubungsanlage nach Anspruch 1, **dadurch gekennzeichnet**, daß eine erste Elektrode (122) mittels Schwenkarmen (123, 124) um einen ersten Drehpunkt (125) drehbar ist, so daß sie aus ihrer Arbeitsposition herausbewegt werden kann und daß eine zweite Elektrode (128) mittels Schwenkarmen (131, 132) um einen zweiten Drehpunkt (134) drehbar ist, so daß sie aus einer Vorbereitungsposition in die Arbeitsposition gebracht werden kann.

8. Zerstäubungsanlage nach Anspruch 1, **dadurch gekennzeichnet**, daß die Vorkammer (5) wenigstens eine Gaszuführung (24, 25) und eine Elektrode (32) aufweist, die der Elektrode (6) mit dem vorzusputternden Target (7) gegenüberliegt.

**9.** Zerstäubungsanlage nach Anspruch 1, **dadurch gekennzeichnet**, daß im Batchbetrieb einer Vakuumanlage die ersten und zweiten Elektroden (3, 6) vor der Belüftung der Prozeßkammer (1) in die unter Vakuum stehende Vorkammer (5) geschwenkt oder gedreht werden.

**10.** Zerstäubungsanlage nach Anspruch 1, **dadurch gekennzeichnet**, daß die erste Elektrode (3) bzw. zweite Elektrode (6) als Flansch zum Schließen der Elektrodenöffnung (9) in der Prozeßkammer (1) dient.

**11.** Zerstäubungsanlage, **gekennzeichnet durch**
a) eine erste Elektrode (3) mit einem ersten Target (2);
b) eine zweite Elektrode (6) mit einem zweiten Target (7);
c) eine Vorrichtung (34 bis 39) zum Annähern und Entfernen der ersten und der zweiten Elektrode (3, 6);
d) eine Einrichtung zum Drehen der Vorrichtung (34 bis 39) mitden Elektroden (3, 6) um einen vorgegebenen Winkel;
e) eine erste Kammer (1) mit einem zu bearbeitenden Substrat (4), in welche das erste Target (2) hineinragt;
f) eine zweite Kammer (5), in welcher sich die zweite Elektrode (6) befindet;
g) eine Anode in der zweiten Kammer (5), die dem Target (7) der zweiten Elektrode (6) gegenüberliegt.

**12.** Zerstäubungsanlage nach Anspruch 11, **dadurch gekennzeichnet**, daß zwischen dem ersten Target (44) und dem zweiten Target (55) ein Exzenter (79) vorgesehen ist, dessen Drehstellung den Abstand zwischen dem ersten und dem zweiten Target (44, 55) bestimmt.

**13.** Zerstäubungsanlage nach Anspruch 12, **dadurch gekennzeichnet**, daß der Exzenter (79) von einem Rohr (84) umgebenist, das über Zylinder (82, 85) mit den Targets (44, 55) in Verbindung steht.

**14.** Zerstäubungsanlage nach Anspruch 11, **dadurch gekennzeichnet**, daß zwischen dem ersten Target (44) und dem zweiten Target (55) Teleskop-Verbindungen (90, 91) vorgesehen sind.

**15.** Zerstäubungsanlage nach Anspruch 1, **dadurch gekennzeichnet**, daß die Vorkammer (5) evakuiert ist und während des Auswechselns einer Targetelektrode durch eine Ersatzelektrode im evakuierten Zustand gehalten wird.

FIG.1

FIG. 2

FIG.3

FIG.4

EP 0 492 114 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | SOLID STATE TECHNOLOGY<br>Bd. 16, Nr. 12, 1. Dezember 1973, WASHINGTON, US<br>Seiten 100 - 103;<br>E.D.SEGAL: 'New geometry in sputtering technology.' | 1-3,5 | C23C14/34<br>C23C14/56 |
| A | * Seite 101, Spalte 1, Zeile 44 - Seite 102, Spalte 1, Zeile 5 *<br>--- | 4,6-15 | |
| A | PATENT ABSTRACTS OF JAPAN<br>vol. 10, no. 139 (C-348)(2196) 22. Mai 1986<br>& JP-A-60 262 969 ( T.D.K. KK ) 26. Dezember 1985<br>* Zusammenfassung *<br><br>----- | 1-15 | |

**RECHERCHIERTE SACHGEBIETE (Int. Cl.5 )**

C23C
H01J

Der vorliegende Recherchenbericht wurde für alle Patentansprüche erstellt

| Recherchenort | Abschlußdatum der Recherche | Prüfer |
|---|---|---|
| DEN HAAG | 04 MAERZ 1992 | EKHULT H.U. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes
    Dokument

EPO FORM 1503 03.82 (P0401)